# EUROPEAN PATENT APPLICATION

(11) **EP 4 803 674 A1**
(43) Date of publication of application: **09.09.2026**
(21) Application number: 24885755.9
(22) Date of filing: 30.10.2024
(51) Int. Cl.: C30B 29/04, C23C 16/27, C30B 25/20, H01L 21/205

(54) **DIAMOND SUBSTRATE, METHOD FOR PRODUCING SAME, AND SENSOR**

(30) Priority: 02.11.2023 JP 2023188333; 08.02.2024 JP 2024018035
(71) Applicant: SHIN-ETSU CHEMICAL CO., LTD., Tokyo 100-0005 (JP); National Institute of Advanced Industrial Science and Technology, Chiyoda-ku Tokyo 100-8921 (JP); Institute of Science Tokyo, Tokyo 152-8550 (JP)
(72) Inventor: NOGUCHI, Hitoshi, Annaka-shi, Gunma 379-0195 (JP); MAKINO, Toshiharu, Tsukuba-shi, Ibaraki 305-8560 (JP); OGURA, Masahiko, Tsukuba-shi, Ibaraki 305-8560 (JP); KATO, Hiromitsu, Tsukuba-shi, Ibaraki 305-8560 (JP); HARUYAMA, Moriyoshi, Tsukuba-shi, Ibaraki 305-8560 (JP); KAJIYAMA, Kenichi, Tokyo 152-8550 (JP); KAINUMA, Yuta, Tokyo 152-8550 (JP); HATANO, Yuji, Tokyo 152-8550 (JP); IWASAKI, Takayuki, Tokyo 152-8550 (JP); HATANO, Mutsuko, Tokyo 152-8550 (JP)
(74) Representative: Schicker, Silvia
(86) International application number: PCT/JP2024/038676
(87) International publication number: WO 2025/094988

(57) **Abstract**

The present invention is a method for manufacturing a diamond substrate by forming a diamond crystal on an underlying substrate by a CVD method, in which in order to form an NVC-containing diamond crystal layer in at least a part of the diamond crystal, a source gas satisfies:
0.005 volume% or more and 7.000 volume% or less of a hydrocarbon gas;
85.000 volume% or more and less than 99.995 volume% of a hydrogen gas; and
5.0×10⁻⁵ volume% or more and 8.000 volume% or less of a nitrogen gas or a nitride gas, and
as the hydrocarbon gas contained in the source gas, a ¹²C-enriched hydrocarbon gas is used, in which a proportion of a hydrocarbon gas having ¹²C is higher than a proportion of the hydrocarbon gas having ¹²C in a natural hydrocarbon gas. This provides the method for manufacturing a diamond substrate capable of forming, on the underlying substrate, the diamond crystal with a highly oriented NV axis (for example, highly [111]-oriented), and a high density of single-spin nitrogen-vacancy centers (NVCs) by performing the CVD under specified conditions.

## Description

### TECHNICAL FIELD

The present invention relates to a diamond substrate, a method for manufacturing the same, and a sensor.

### BACKGROUND ART

Diamond has a wide band gap of 5.47 eV at room temperature and is known as a wide bandgap semiconductor.

Among wide bandgap semiconductors, diamond has an extremely high dielectric breakdown electric field strength of 10 MV/cm, and high-voltage operation can be performed. In addition, diamond has the highest thermal conductivity among known materials and thus has an excellent heat radiation property. Further, diamond has a very large carrier mobility and saturated drift velocity and is suitable for a high-speed device.

Accordingly, diamond has the highest Johnson's figure of merit, which indicates a property as a radio-frequency and high-power device, compared to semiconductors such as silicon carbide and gallium nitride, and is thus said to be an ultimate semiconductor.

Further, diamond is characterized by a phenomenon of a nitrogen-vacancy center (NVC) in the crystal, thereby enabling manipulation and detection of a single spin at room temperature. The states of the single spin can be imaged by optically detected magnetic resonance. Making use of this characteristic, application in a wide field of high-sensitivity sensors for magnetic field, electric field, temperature, and pressure, etc., is expected.

### CITATION LIST

### PATENT LITERATURE

Patent Document 1: US 2013/0143022 A1

### NON PATENT LITERATURE

Non Patent Document 1: M.Hatano et al., OYOBUTURI 85, 311 (2016)
Non Patent Document 2: T.Fukui, et al., APEX 7,055201 (2014).
Non Patent Document 3: H.Ozawa, et.al., NDF Dia.Symp. 29, 16 (2015).

### SUMMARY OF INVENTION

### TECHNICAL PROBLEM

As described above, diamond is expected to be used practically as a material for semiconductors or a material for electronic and magnetic devices, and a supply of a diamond substrate with a large area and high quality is desired. For example, in Patent Document 1, a technology to form a diamond (111) crystal by heteroepitaxial growth using a chemical vapor deposition method is reported. In particular, for use in an NVC device, having high importance among uses for diamond, a nitrogen-vacancy axis (NV axis) has to be highly oriented, and therefore, the diamond surface is desirably a (111) crystal surface with the NV axis aligned in a [111] direction (Non Patent Document 1). In addition, for example, considering application in an MRI field for medical purposes, a device that can measure a wider range efficiently can be realized with a diamond substrate that has a large diameter as the magnetic sensor portion. In addition, there is also an advantage in terms of manufacturing costs.

In addition, when the diamond substrate is used for electronic and magnetic devices, in the sensor portion, the NV axis not only needs to be aligned in a [111] direction in the diamond crystal but also needs to be formed in a high density.

Fabrication of a diamond crystal having a high density of NVCs and a [111] orientation that has been reported to date is as follows.

It has been studied to use a single crystal diamond synthesized by a high-pressure-high-temperature (HPHT) synthesis method as an underlying substrate, and to grow a diamond crystal by a microwave chemical vapor deposition (CVD) method by adding nitrogen to hydrogen-diluted methane (Non Patent Documents 2 and 3).

However, in the reported documents, only HPHT Ib (111), which is difficult to obtain in large sizes in practice, is used as a base substrate, and furthermore, in Non Patent Document 2, details of the gas composition in the CVD are unclear. In addition, in Non Patent Document 3, it is unclear whether the CVD conditions in the document have been optimized.

The present invention has been made to solve the above problems. An object thereof is to provide a method for manufacturing a diamond substrate, by performing CVD under specified conditions, which is capable of forming, on an underlying substrate, a diamond crystal with a highly oriented NV axis (for example, high [111] orientation), and a high density of single-spin nitrogen-vacancy centers (NVCs). In addition, an object of the present invention is also to provide such a diamond substrate. Further, an object of the present invention is also to provide a sensor using a diamond substrate containing the NVCs.

### SOLUTION TO PROBLEM

The present invention has been made to achieve the above object, and provides a method for manufacturing a diamond substrate by forming a diamond crystal on an underlying substrate using a source gas containing a hydrogen gas as a dilution gas and a hydrocarbon gas by a chemical vapor deposition (CVD) method, wherein
in order to form a diamond crystal layer having nitrogen-vacancy centers in at least a part of the diamond crystal to be formed on the underlying substrate, a nitrogen gas or a nitride gas is mixed in the source gas, and amounts of respective gases contained in the source gas satisfy:
0.005 volume% or more and 7.000 volume% or less of the hydrocarbon gas;
85.000 volume% or more and less than 99.995 volume% of the hydrogen gas; and
5.0×10⁻⁵ volume% or more and 8.000 volume% or less of the nitrogen gas or the nitride gas,
to thereby form the diamond crystal layer having the nitrogen-vacancy centers, and
as the hydrocarbon gas contained in the source gas, a ¹²C-enriched hydrocarbon gas is used, in which a proportion of a hydrocarbon gas having ¹²C, which is an isotope of carbon, is higher than a proportion of the hydrocarbon gas having ¹²C in a natural hydrocarbon gas.

According to the method for manufacturing a diamond substrate with such CVD conditions, a diamond substrate in which the diamond crystal layer is formed can be manufactured, the diamond crystal layer having high crystallinity, a highly oriented NV axis (in particular, highly [111]-oriented), and a high density of single-spin NVCs. Such a diamond crystal can be used suitably for electronic and magnetic devices.

In this case, the source gas can further contain an oxygen gas or an oxide gas in an amount of 0.010 volume% or more and 2.000 volume% or less.

In this manner, an oxygen etching effect to remove a non-diamond component can be appropriately obtained, thereby enabling further improvement of the orientation of the diamond crystal.

Moreover, the hydrocarbon gas contained in the source gas can be a methane gas.

When using the methane gas in this way, it is preferable because a high-purity gas is available with ease at a low cost, and is easy to handle.

Moreover, a gas pressure in the formation of the diamond crystal by the CVD method can be 1.3 kPa (10 Torr) or more and 50.0 kPa (376 Torr) or less.

Under such gas pressure conditions, growth of non-single crystal diamond can be suppressed more effectively, and a single crystal diamond having high crystallinity can be obtained.

Moreover, the ¹²C-enriched hydrocarbon gas can have a volume ratio of the hydrocarbon gas having ¹²C in the ¹²C-enriched hydrocarbon gas of 99.950 volume% or more.

In this manner, the formation of the high density of single-spin NVCs is achieved more effectively.

Moreover, the ¹²C-enriched hydrocarbon gas can have a volume ratio of the hydrocarbon gas having ¹³C in the ¹²C-enriched hydrocarbon gas of 0.040 volume% or less.

In this way, the formation of the high density of single-spin NVCs is achieved further effectively.

Moreover, the underlying substrate can be a single layer substrate of a single crystal diamond.

By adopting the single crystal diamond for the underlying substrate, it is possible to more effectively align the NV axis of the NVC-containing diamond crystal in a highly oriented (in particular, highly [111]-oriented) manner and form in a high density.

By using such a single crystal diamond (in particular, single crystal diamond (111)) for the underlying substrate, step-flow growth is facilitated, thereby enabling the formation of a resulting single-crystal diamond of high quality, having few hillocks, abnormal growth particles, dislocation defects, and the like.

Moreover, the single layer substrate of a single crystal diamond can be any of a high-pressure-high-temperature-synthesized single crystal diamond layer, a heteroepitaxial single crystal diamond layer, or a CVD-synthesized homoepitaxial diamond layer.

As the underlying substrate in the inventive method for manufacturing a diamond substrate, a substrate composed of these single crystal diamond layers can be suitably adopted.

Moreover, in forming the diamond crystal by the CVD method, when forming a diamond crystal layer that does not contain the nitrogen-vacancy centers, the natural hydrocarbon gas can be used.

In this way, manufacturing costs can be further reduced.

Moreover, the underlying substrate can have a laminated structure comprising an underlayer substrate and an intermediate layer on the underlayer substrate.

In the present invention, a substrate having such a laminated structure can also be adopted.

In this case, the intermediate layer can have an outermost surface that is a metal layer selected from Ir, Rh, Pd, and Pt.

By forming the outermost surface of the intermediate layer with such kinds of metal layer, diamond nuclei tend to have high density when a nucleation treatment (bias treatment) is performed, and the single crystal diamond layer is more easily formed thereon.

Moreover, the CVD method can comprise any one or more of a microwave plasma CVD method, a direct current plasma CVD method, a hot-filament CVD method, and an arc discharge plasma jet CVD method.

It is possible to employ one of these CVD methods suitably. Alternatively, it is also possible to suitably employ these methods in combination.

Moreover, in the present invention, the underlying substrate can also be removed from the diamond substrate comprising the diamond crystal layer having the nitrogen-vacancy centers obtained by the method for manufacturing a diamond substrate described above, to obtain a freestanding single crystal diamond substrate comprising the diamond crystal layer having the nitrogen-vacancy centers.

Accordingly, the freestanding single crystal diamond substrate can be obtained, the freestanding single crystal diamond substrate containing the diamond crystal layer having high crystallinity, a highly oriented NV axis (in particular, highly [111]-oriented), and a high density of single-spin NVCs. This freestanding single crystal diamond substrate can be applied to electronic and magnetic devices.

Moreover, it is also possible to smooth a surface of the diamond crystal layer having the nitrogen-vacancy centers of the diamond substrate comprising the diamond crystal layer having the nitrogen-vacancy centers obtained by the method for manufacturing a diamond substrate described above.

In this manner, irregular reflection of light on the surface of the diamond crystal layer having the NVC is suppressed, and thus, NV-center light that can be obtained can be increased.

Moreover, the present invention provides a diamond substrate comprising a diamond crystal layer having nitrogen-vacancy centers, wherein
the diamond crystal layer having the nitrogen-vacancy centers is formed on a diamond crystal layer that does not contain the nitrogen-vacancy centers or a single layer substrate of a single crystal diamond,
in carbon atoms present in the diamond crystal layer having the nitrogen-vacancy centers, an abundance ratio of ¹²C, which is an isotope of carbon, is higher than an abundance ratio in natural carbon atoms, and
a profile of a nitrogen concentration in the diamond crystal layer having the nitrogen-vacancy centers is steep in an interfacial region with the diamond crystal layer that does not contain the nitrogen-vacancy centers or with the single layer substrate of a single crystal diamond.

Such a diamond substrate has high crystallinity, a highly oriented NV axis (in particular, highly [111]-oriented), and a high density of single-spin NVCs. In addition, for this reason, the diamond substrate can be applied to electronic and magnetic devices.

In particular, when the profile of the nitrogen concentration in the diamond crystal layer having the nitrogen-vacancy centers is measured by a secondary ion mass spectrometry apparatus using Cs⁺ as primary ion species, at a primary accelerating voltage of 16.0 kV, and with a detection area diameter of 30 µm, a thickness of a decreasing region of the profile of the nitrogen concentration until the nitrogen concentration [N] reaches 1/e (Napier's constant) times is preferably 1.5 µm or less in the interfacial region with the diamond crystal layer that does not contain the nitrogen-vacancy centers or the single layer substrate of a single crystal diamond.

With physical properties exhibiting such a steep decrease in the nitrogen concentration at the interfacial region between the layer having NVCs and the layer without NVCs, the diamond substrate having the NVC-containing diamond crystal with more improved characteristics can be obtained.

Moreover, a hydrogen concentration [H] can be 1×10¹⁶ atoms/cm³ or more in the diamond crystal layer having the nitrogen-vacancy centers.

When the CVD method is employed among diamond growth methods, unlike a high-pressure-high-temperature-synthesized diamond, the hydrogen concentration in the diamond crystal layer becomes relatively high.

Moreover, the nitrogen concentration [N] in the diamond crystal layer having the nitrogen-vacancy centers can be 1×10¹⁷ atoms/cm³ ≤ [N] ≤ 9×10¹⁹ atoms/cm³.

The diamond substrate having the nitrogen concentration within such a range can serve as a diamond substrate having an NVC-containing diamond crystal with more favorable characteristics.

Moreover, an average surface roughness Ra of a surface of the diamond crystal layer having the nitrogen-vacancy centers is preferably Ra ≤ 260 nm.

With such a surface roughness, irregular reflection of light on the surface of the diamond crystal layer having the NVCs is suppressed, and thus the NV-center light that can be obtained can be increased.

Moreover, the present invention provides a sensor comprising the diamond substrate according to any one of the descriptions above.

The sensor employing the inventive diamond substrate becomes a highly sensitive and excellent sensor.

### ADVANTAGEOUS EFFECTS OF INVENTION

According to the inventive method for manufacturing a diamond substrate, a diamond substrate in which the diamond crystal layer is formed can be manufactured, the diamond crystal layer having high crystallinity, a highly oriented NV axis (in particular, highly [111]-oriented), and a high density of single-spin NVCs. Such a diamond crystal can be used suitably for electronic and magnetic devices.

Moreover, according to the inventive diamond substrate, it is possible to provide a diamond substrate that has high crystallinity, a highly [111]-oriented NV axis, and a high density of single-spin NVCs, and that can be applied to electronic and magnetic devices.

Furthermore, according to the inventive sensor, the sensor can be a highly sensitive and excellent sensor.

### BRIEF DESCRIPTION OF DRAWINGS

[FIG. 1] is a schematic view illustrating an example of a diamond substrate (NVC-containing layer and NVC-free single layer substrate) according to the present invention.
[FIG. 2] is a schematic view illustrating an example of a diamond substrate (NVC-containing layer, NVC-free layer, and underlying substrate of laminated structure) according to the present invention.
[FIG. 3] is a schematic view illustrating an example of a diamond substrate (NVC-containing layer and underlying substrate) manufactured by a method for manufacturing a diamond substrate according to the present invention.
[FIG. 4] is a schematic view illustrating an example of a diamond substrate (NVC-containing layer and underlying substrate of laminated structure) manufactured by a method for manufacturing a diamond substrate according to the present invention.
[FIG. 5] is a schematic view illustrating an example of a diamond substrate (NVC-containing layer, NVC-free layer, and underlying substrate of laminate structure) manufactured by a method for manufacturing a diamond substrate according to the present invention.
[FIG. 6] is a schematic view illustrating an example of a freestanding single crystal diamond substrate (NVC-containing layer and NVC-free layer) obtained by a method for manufacturing a diamond substrate according to the present invention.
[FIG. 7] is a graph showing SIMS measurement results in Example 1.

### DESCRIPTION OF EMBODIMENTS

Hereinafter, the present invention will be described in detail, but the present invention is not limited thereto.

As described above, it has been desired to obtain a diamond substrate that is suitable for electronic and magnetic devices, and that has a large diameter, high crystallinity, a highly oriented NV axis (for example, highly [111]-oriented), and a high density of single-spin NVCs.

The present inventors have keenly studied the above problems and found out that a method for manufacturing a diamond substrate by forming a diamond crystal on an underlying substrate using a source gas containing a hydrogen gas as a dilution gas and a hydrocarbon gas by a CVD method, in which in order to form a diamond crystal layer having nitrogen-vacancy centers in at least a part of the diamond crystal to be formed on the underlying substrate, a nitrogen gas or a nitride gas is mixed in the source gas, and amounts of respective gases contained in the source gas satisfy:
0.005 volume% or more and 7.000 volume% or less of the hydrocarbon gas;
85.000 volume% or more and less than 99.995 volume% of the hydrogen gas; and
5.0×10⁻⁵ volume% or more and 8.000 volume% or less of the nitrogen gas or the nitride gas,
to thereby form the diamond crystal layer having the nitrogen-vacancy centers, and as the hydrocarbon gas contained in the source gas, a ¹²C-enriched hydrocarbon gas is used, in which a proportion of a hydrocarbon gas having ¹²C, which is an isotope of carbon, is higher than a proportion of the hydrocarbon gas having ¹²C in a natural hydrocarbon gas, and thereby found that this method makes it possible to obtain a diamond substrate having high crystallinity, a highly oriented NV axis (highly [111]-oriented), and a high density of single-spin NVCs, and completed the present invention.

In addition, the present inventors found out that a diamond substrate including a diamond crystal layer having nitrogen-vacancy centers, in which the diamond crystal layer having the nitrogen-vacancy centers is formed on a diamond crystal layer that does not contain the nitrogen-vacancy centers or a single layer substrate of a single crystal diamond, in carbon atoms present in the diamond crystal layer having the nitrogen-vacancy centers, an abundance ratio of ¹²C, which is an isotope of carbon, is higher than an abundance ratio in natural carbon atoms, and a profile of a nitrogen concentration in the diamond crystal layer having the nitrogen-vacancy centers is steep in an interfacial region with the diamond crystal layer that does not contain the nitrogen-vacancy centers or with the single layer substrate of a single crystal diamond, and thereby found out that this diamond substrate also makes it possible to solve the above problems, and completed the present invention.

In the present description, for the sake of simplicity, the diamond crystal layer having the nitrogen-vacancy center (NVC) may be referred to as a NVC-containing layer, and the diamond crystal layer that does not contain NVC may be referred to as a NVC-free layer. In addition, the single layer substrate of a single crystal diamond that does not contain NVC may be referred to as a NVC-free single layer substrate.

Furthermore, regarding the layers and the substrates described above, in particular, the following description will be given, referring to cases in which a diamond crystal layer and a single layer substrate both having a main surface of (111) (also respectively referred to as single crystal diamond (111) layer and single crystal diamond (111) substrate) as examples; however, the present invention is not limited thereto.

### (Inventive Diamond Substrate and Inventive Sensor)

The inventive diamond substrate will be described. The inventive diamond substrate is a diamond substrate containing the NVC-containing layer, and the NVC-containing layer is formed on the NVC-free single layer substrate or on the NVC-free layer.

### (First Embodiment)

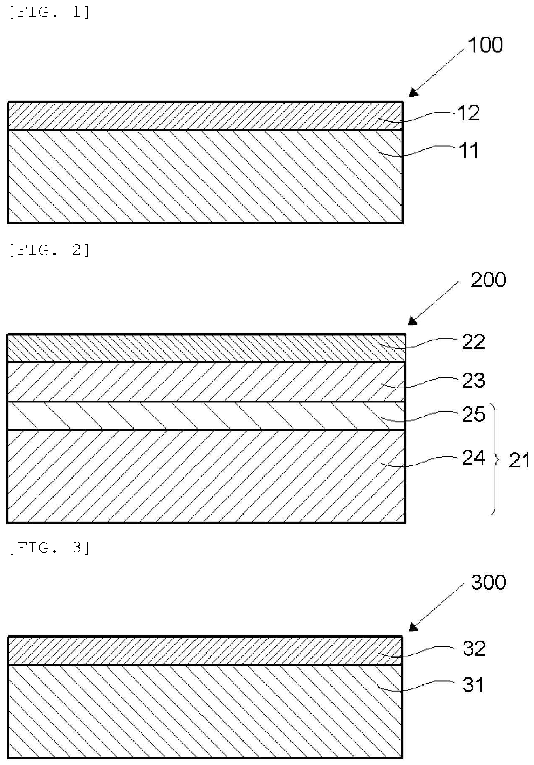

First, an example of the former substrate will be described with reference to FIG. 1. As shown in FIG. 1, in the inventive diamond substrate 100, a NVC-containing layer 12 is formed on an underlying substrate 11, which is a NVC-free single layer substrate (single crystal diamond (111) substrate).

Moreover, in the NVC-containing layer 12, an abundance ratio of ¹²C, which is an isotope of carbon, in carbon atoms present in the NVC-containing layer 12 is higher than the abundance ratio in natural carbon atoms.

Note that the abundance ratio in the natural carbon atoms described here may refer to a widely known abundance ratio having 98.89% of ¹²C and 1.11% of ¹³C.

On the other hand, an abundance ratio of ¹²C in a NVC-free single layer substrate used for the underlying substrate 11 is not particularly limited, but, in particular, can be comparable to the abundance ratio in natural carbon atoms.

In addition, a profile of a nitrogen concentration in the NVC-containing layer 12 is steep in an interfacial region with the underlying substrate 11, and decreases steeply from the NVC-containing layer 12 side toward the underlying substrate 11 side.

For example, a specific degree of this steepness is as follows. When the profile of the nitrogen concentration in the NVC-containing layer 12 is measured by a secondary ion mass spectrometry (SIMS: Secondary Ion Mass Spectrometry) apparatus using Cs⁺ as primary ion species, at a primary accelerating voltage of 16.0 kV, and with a detection area diameter of 30 µm, a thickness of a decreasing region of the profile of the nitrogen concentration until the nitrogen concentration [N] reaches 1/e (Napier's constant) times is 1.5 µm or less in the interfacial region described above.

The thickness of the decreasing region exhibiting steepness is preferably as small as possible, and the lower limit thereof is not particularly limited. However, the thickness can be, for example, 1.0 µm, more preferably 0.5 µm.

Note that, by way of example, CAMECA IMS-7f (manufactured by AMETEK, Inc.) may be used as the secondary ion mass spectrometry apparatus.

The inventive diamond substrate 100 in this manner has high crystallinity, a highly [111]-oriented NV axis, and a high density of single-spin NVCs, and thus can be applied to electronic and magnetic devices.

Here, when the NVC-containing layer 12 is measured by the SIMS apparatus CAMECA IMS-7f described above with Cs⁺ as primary ion species, at a primary accelerating voltage of 16.0 kV, and with a detection area diameter of 30 µm, the NVC-containing layer 12 can have a hydrogen concentration [H] of 1×10¹⁶ atoms/cm³ or more. As described later, when the layer is formed by the CVD method, the layer becomes a layer having such a relatively high hydrogen concentration.

Note that the upper limit of the hydrogen concentration is not particularly limited, but can be 1×10¹⁸ atoms/cm³, for example.

Further, the nitrogen concentration [N] in the NVC-containing layer 12 preferably satisfies 1×10¹⁷ atoms/cm³ ≤ [N] ≤ 9×10¹⁹ atoms/cm³. With such a nitrogen concentration, the diamond substrate can have the NVC-containing layer having more favorable characteristics.

Moreover, an average surface roughness Ra of a surface of the NVC-containing layer is preferably Ra ≤ 260 nm, because irregular reflection of light thereon is suppressed, and thus NV-center light that can be obtained can be increased.

Note that it is favorable that the average surface roughness Ra is as small as possible concerning the relation with the irregular reflection of light described above, and is therefore not limited to a specified roughness value. However, the roughness Ra can be, for example, 200 nm.

By way of example, the following method may be used as a method for measuring the average surface roughness Ra.

### (Measuring Method)

By employing an Atomic Force Microscopy (AFM: Atomic Force Microscopy) apparatus, for example, NanoScope V / Dimension Icon manufactured by Bruker AXS SE, the measurement of the surface roughness Ra is performed in a tapping mode over an area of 80 µm × 80 µm.

### (Second Embodiment)

Next, an example of the latter will be described with reference to FIG. 2. As shown in FIG. 2, in the inventive diamond substrate 200, a NVC-free layer 23 is formed on an underlying substrate 21, and a NVC-containing layer 22 is formed on the NVC-free layer 23.

The underlying substrate 21 is not particularly limited, and can be a NVC-free single layer substrate as in the diamond substrate 100 in FIG. 1. Alternatively, the underlying substrate 21 can be a laminated structure including of an underlayer substrate 24 and an intermediate layer 25 thereon, as shown in FIG. 2. For example, the underlayer substrate 24 may be a single crystal MgO substrate. Moreover, the intermediate layer 25 may be a single layer or a laminate composed of a plurality of layers. Furthermore, the intermediate layer may have an outermost surface, which is a metal layer selected from Ir, Rh, Pd, and Pt.

Further, regarding a NVC-free layer 23, an abundance ratio of ¹²C in this layer is not particularly limited but can be, for example, comparable to the abundance ratio in natural carbon atoms.

Note that a steepness of a profile of the nitrogen concentration in the NVC-containing layer 22 at an interfacial region with the NVC-free layer 23 and the degree thereof can be the same as the steepness and the degree thereof in the NVC-containing layer 12 at an interfacial region with the underlying substrate 11 in FIG. 1 described earlier.

In addition, in the NVC-containing layer 22, a range of a hydrogen concentration, a range of a nitrogen concentration, and a range of average surface roughness Ra on a surface of this layer can be also the same as corresponding parameters in the NVC-containing layer 12 in FIG. 1.

Such a diamond substrate 200 also has high crystallinity, a highly [111]-oriented NV axis, and a high density of single-spin NVCs, and thus is suitable for electronic and magnetic devices.

Accordingly, examples of various types of the inventive sensors employing the inventive diamond substrates 100 and 200 include a current sensor, a temperature sensor, and a biomagnetic sensor, each of which exhibits high sensitivity and excellent performance.

### (Inventive Method for Manufacturing Diamond Substrate)

Next, the inventive method for manufacturing a diamond substrate will be described. First, an outline thereof will be described.

A diamond substrate is manufactured by forming a diamond crystal on an underlying substrate using a source gas containing a hydrogen gas as a dilution gas and a hydrocarbon gas by a CVD method. Note that examples of the CVD (chemical vapor deposition) method include a microwave plasma CVD method, a direct current plasma CVD method, a hot-filament CVD method, and an arc discharge plasma jet CVD method. Among these, the diamond obtained by the microwave plasma CVD method or the direct current plasma CVD method is a single-crystal diamond of high quality, having high crystallinity, few hillocks, few abnormal growth particles, few dislocation defects, and favorable impurity controllability. Furthermore, a plurality of the above CVD methods may be combined to perform CVD. For example, a combination of the direct current plasma CVD method and the microwave plasma CVD method enables simultaneous nuclei formation and film growth of the diamond. A combination of the direct current plasma CVD method and the hot-filament CVD method enable simultaneous nuclei formation and film growth over a large area of the diamond.

At this time, in order to form a NVC-containing layer at least in a part of the above diamond crystal, at least the nitrogen gas or the nitride gas is mixed in the source gas (depending on the necessity, oxygen gas or oxide gas may be further mixed therein), and amounts of respective gases (hydrocarbon gas, hydrogen gas, nitrogen gas or nitride gas (further, oxygen gas or oxide gas)) contained in the source gas are limited within predetermined ranges as described later.

Furthermore, as the above hydrocarbon gas contained in the source gas, a ¹²C-enriched hydrocarbon gas is used, in which a proportion of the hydrocarbon gas having ¹²C, which is an isotope of carbon, is higher than a proportion of the hydrocarbon gas having ¹²C in a natural hydrocarbon gas.

Hereinafter, a further detailed description will be provided.

### (First Manufacturing Embodiment)

In order to form a NO axis with a high density and high [111] orientation, an underlying substrate is preferably a single layer substrate of a single crystal diamond. In particular, a single crystal diamond (111) is preferably used as the underlying substrate for epitaxial growth. FIG. 3 shows a diamond substrate 300 in which a NVC-containing layer 32 is formed on an underlying substrate 31. As described in FIG. 3, it is preferable to use the single layer substrate of a single crystal diamond, in particular, the single crystal diamond (111) as the underlying substrate 31.

Moreover, the single layer substrate of a single crystal diamond used as the underlying substrate 31 can be any of a high-pressure-high-temperature-synthesized single crystal diamond layer, a heteroepitaxial single crystal diamond layer, or a CVD-synthesized homoepitaxial diamond layer. In the inventive manufacturing method, these single crystal diamonds are suitably used as the underlying substrate 31.

In the source gas to form the NVC-containing layer 32, a methane gas, acetylene, ethylene, ethane, and propane can be used as a hydrocarbon gas; however, the methane gas is preferred because a high-purity gas is easily available at low cost and can be easily handled.

When an amount of the hydrocarbon gas, such as a methane gas, is less than 0.005 volume%, the etching effect by hydrogen is increased, and it becomes difficult for diamond to grow. A preferable range for the amount of the hydrocarbon gas is 0.005 volume% or more, more preferably 0.01% or more, and most preferably 0.05 volume% or more.

On the other hand, when the amount of the hydrocarbon gas exceeds 7.000 volume%, a prolonged growth causes the diamond to become polycrystalline and prevents obtaining a high-quality single crystal. Accordingly, the amount of the hydrocarbon gas is to be set in a range of 7.000 volume% or less, preferably 6.5 volume% or less, and more preferably 6.0 volume% or less.

In addition, in this source gas, when the amount of the nitrogen gas or the nitride gas is less than 5.0×10⁻⁵ volume%, the doped amount of nitrogen in the diamond crystal is too little, and the NVC density also becomes lowered. Accordingly, the amount of the nitrogen gas or the nitride gas is to be set in a range of 5.0×10⁻⁵ volume% or more, preferably 5.0×10⁻⁴ volume% or more, and more preferably 1.0×10⁻³ volume% or more.

On the other hand, when the amount of the nitrogen gas or the nitride gas exceeds 8.000 volume%, a prolonged growth causes the diamond to become polycrystalline and prevents obtaining a high-quality single crystal. Accordingly, the amount of the nitrogen gas or the nitride gas is to be set to 8.000 volume% or less, and a more preferable range thereof is 0.500 volume% or less.

Ammonia, nitrogen oxide, nitrogen dioxide, and other gases can be used as the nitride gas, and nitrogen gas is preferable, because a high-purity gas is easily available at low cost, and can be easily handled.

Moreover, it is preferable to add the oxygen gas or the oxide gas because a non-diamond component is removed, and thus the orientation of the diamond crystal is further improved. When adding the oxygen gas or the oxide gas, by setting the amount thereof to 0.010 volume% or more, it is possible to obtain an appropriate oxygen etching effect. On the other hand, by setting the amount of oxygen to 2.000 volume% or less, it is possible to effectively prevent the inhibition of the diamond growth caused by an excessively large etching effect due to oxygen.

Note that the appropriate amount of the hydrogen gas, which is a dilution gas, is 85.000 volume% or more and less than 99.995 volume%.

In this case, when a gas pressure during the formation of the diamond crystal by respective CVD methods is set to 1.3 kPa (10 Torr) or more and 50.0 kPa (376 Torr) or less, polycrystallization of the diamond can be effectively prevented, thereby enabling the formation of a single crystal of high quality.

In order to effectively prevent difficulty in discharge generation and too low plasma density for obtaining the high-quality single crystal diamond, which are caused by excessively low gas pressure, the lower limit of the gas pressure is to be set as described above, and is preferably in a range of 12.0 kPa (90 Torr) or more.

On the other hand, in order to effectively prevent problems caused by excessively high gas pressure, including a similar difficulty in discharge generation, deteriorated crystallinity due to higher temperatures, and further, a reduction in the diamond formation region, the upper limit of the gas pressure is to be set as described above, and is more preferably 33.3 kPa (250 Torr) or less.

Moreover, when a ¹²C-enriched hydrocarbon gas is used as the hydrocarbon gas contained in the source gas for the CVD method, it becomes possible to form the high-density NVCs. This ¹²C-enriched hydrocarbon gas has a proportion of a hydrocarbon gas having ¹²C isotope, which is an isotope of carbon, being higher than a proportion of the hydrocarbon gas having ¹²C in a natural hydrocarbon gas. This makes it possible to realize a highly sensitive sensor (e.g., magnetic sensor).

Here, an example of the proportion in the natural hydrocarbon gas includes a proportion (e.g., volume ratio), in which the proportion of hydrocarbon gas having ¹²C is 98.89%, and the proportion of a hydrocarbon gas having ¹³C is 1.11%.

Consequently, by using ¹²C-enriched hydrocarbon gas having the proportion described above, the diamond crystal can also be formed in which an abundance ratio of ¹²C in the crystal is higher than the abundance ratio in natural carbon atoms.

When a gas in which the hydrocarbon gas having ¹²C has a volume ratio of 99.950 volume% or more (100 volume% or less) is used as the ¹²C-enriched hydrocarbon gas, it is effective for forming the high density of single-spin NVCs.

Moreover, the reduction of the amount of the hydrocarbon gas having ¹³C, which is the second most abundant after ¹²C among the carbon isotopes, is also effective for forming high-density NVCs. In particular, setting the hydrocarbon gas having ¹³C contained in the ¹²C-enriched hydrocarbon gas to 0.040 volume% or less (0 volume% or more) is also sufficiently effective for forming the high density of single-spin NVCs.

An adjustment of the volume% of the hydrocarbon gas having ¹²C or the hydrocarbon gas having ¹³C, which are contained in the ¹²C-enriched hydrocarbon gas, can be performed by, for example, using commercially available gases with high purity for respective gas.

Note that when the diamond substrate 300 in FIG. 3 is manufactured using a NVC-free single layer substrate as the underlying substrate 31, the same substrate as in the diamond substrate 100 shown in FIG. 1 can be manufactured.

In this way, the diamond substrate can be manufactured, in which the diamond crystal layer with high crystallinity, a highly [111]-oriented NV axis, and a high density of single-spin NVCs is formed. This diamond substrate is suitable for a substrate for various devices (substrate for a sensor).

### (Second Manufacturing Embodiment)

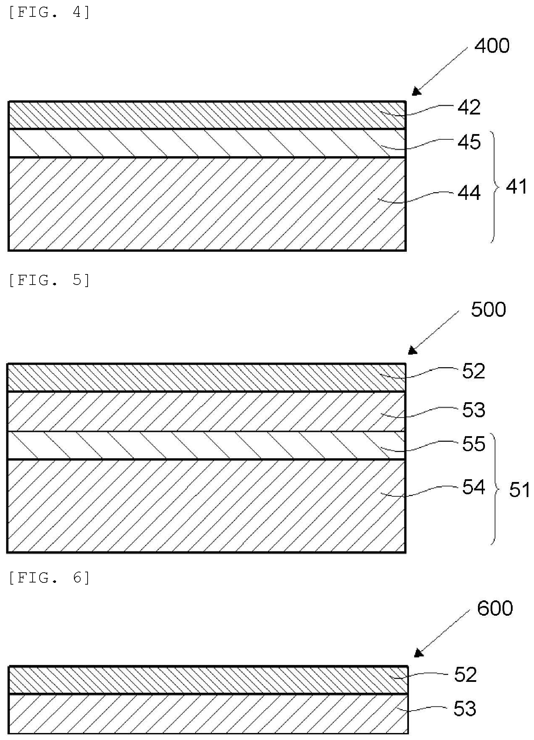

In addition, in the inventive method for manufacturing a diamond substrate, an underlying substrate may have a laminated structure including an underlayer substrate and an intermediate layer on the underlayer substrate. FIG. 4 shows a diamond substrate 400 in which a NVC-containing layer is formed on the underlying substrate of a laminated structure. That is, the diamond substrate 400 in FIG. 4 has a laminated structure composed of an underlayer substrate 44 and an intermediate layer 45 as an underlying substrate 41. This diamond substrate 400 has such an underlying substrate 41 on which a NVC-containing layer 42 is formed.

The underlayer substrate 44 is not particularly limited and, for example, a single crystal MgO substrate or the like can be used.

The intermediate layer 45 may be a single layer or a laminate having a plurality of layers. The intermediate layer 45 preferably has an outermost surface that is a metal layer selected from, for example, Ir, Rh, Pd, and Pt. By using such a metal layer, diamond nuclei tend to have high density when a nucleation treatment (bias treatment) is performed, and the single crystal diamond layer is more easily formed thereon, and is therefore preferable.

### (Third Manufacturing Embodiment)

Further, as shown in FIG. 5, a diamond substrate 500 can also be manufactured, in which a nitrogen-undoped diamond layer (NVC-free layer) 53 (made of single crystal) and a NVC-containing layer 52 (made of a single crystal) are formed in this order on an underlying substrate 51 of a laminated structure (underlayer substrate 54 and intermediate layer 55).

When forming the NVC-free layer 53, it is preferable to use a natural hydrocarbon gas for formation. This is because the manufacturing cost can be further reduced by the above procedure.

In particular, as the diamond 500 in FIG. 5, the same substrate as in the diamond substrate 200 shown in FIG. 2 can be manufactured.

Note that the conditions in the second and third manufacturing embodiments are identical to the conditions in the first manufacturing embodiment, in which the conditions include amounts of respective gases (hydrocarbon gas, hydrogen gas, nitrogen gas, or nitride gas) during the formation of the NVC-containing layer, and "the proportion of hydrocarbon gas having ¹²C contained in the ¹²C-enriched hydrocarbon gas > the proportion of that in the natural hydrocarbon gas". Moreover, it is possible to set the conditions regarding the use of the oxygen gas or the oxide gas, the gas pressure, and other conditions described above to the identical conditions in the first manufacturing embodiment.

Moreover, each of the first to third manufacturing embodiments may include a step of smoothing a surface of the NVC-containing layer. Mechanical polishing, chemical-mechanical polishing, plasma treatment, sputtering treatment, chemical etching or the like may be applied for smoothing thereon. When an average surface roughness Ra on the surface of the NVC-containing layer is set to, for example, 260 nm or less (0 nm or more), irregular reflection of light is suppressed, and thus NV-center light that can be obtained can be increased.

In addition, in the present invention, the underlying substrate can be removed from the diamond substrate having the NVC-containing layer on the underlying substrate, the diamond substrate being obtained by the method for manufacturing a diamond substrate described above. Accordingly, a freestanding single crystal diamond substrate including the NVC-containing layer can be obtained. Thus, a diamond substrate having an increased ratio of a NVC-containing portion allows reduction of the cause of noise in practical usage, and therefore, highly sensitive electric and magnetic devices can be realized.

Note that when the underlying substrate is a single layer, as in the first manufacturing embodiment, the entire underlying substrate can be removed. Meanwhile, when the underlying substrate is composed of the underlayer substrate and the intermediate layer, as in the second and third manufacturing embodiments, the underlayer substrate alone may be removed, or both of the underlayer substrate and the intermediate layer can be removed. In addition, a part of the underlying substrate may be removed. Furthermore, the nitrogen-undoped diamond layer may also be removed, thereby leaving only the NVC-containing layer.

FIG. 6 shows a manufacturing example of this freestanding single crystal diamond substrate. In this example, the underlying substrate 51 portion (underlayer substrate 54 and intermediate layer 55) is removed from the diamond substrate 500 in FIG. 5; consequently, a diamond substrate 600 (freestanding structure substrate made of diamond substrate) composed of the NVC-containing layer 52 and the nitrogen-undoped diamond layer (NVC-free layer) 53 is produced.

Note that the removal method of the underlying substrate is not particularly limited. A mechanical treatment, such as polishing, an optical treatment, such as a laser, a wet or dry etching treatment or the like may be appropriately selected according to the materials of the underlying substrate, the underlayer substrate, and the intermediate layer. The above treatments may also be combined.

### EXAMPLES

Hereinafter, the present invention will be specifically described with reference to Examples. However, the present invention is not limited to these Examples.

### (Example 1)

As an underlayer substrate in an underlying substrate, a single crystal MgO substrate polished on one side having a diameter of 10.0 mm, a thickness of 1.0 mm, a main surface that was a (111) plane, and an off angle of 4° in a crystal axis [-1-1 2] direction (hereinafter referred to as "single crystal MgO (111) substrate") was provided.

Next, an intermediate layer of a single crystal Ir film was formed by a R. F. magnetron sputtering method on the surface of the provided single crystal MgO (111) substrate. The single crystal Ir film was formed by a radio-frequency (RF) magnetron sputtering method (13.56 MHz) with targeting at Ir having a diameter of 6 inches (150 mm), a thickness of 5.0 mm, and a purity of 99.9% or more.

The single crystal MgO (111) substrate, being an underlayer substrate, was heated to 840°C, and after it was confirmed that a base pressure had become 6×10⁻⁷ Torr (about 8.0×10⁻⁵ Pa) or lower, 50 sccm of Ar gas was introduced. Next, after making the pressure 3×10⁻¹ Torr (about 39.9 Pa) by adjusting the aperture of the valve connected to the exhaust system, film formation was performed for 15 minutes by inputting RF power of 1000 W. In this manner, a single crystal Ir film with a thickness of 1.0 µm was obtained.

The single crystal MgO (111) substrate on which a single crystal Ir film was laminated, which is obtained as described above, grew heteroepitaxially in accordance with the off-angle of the single crystal MgO substrate. This single crystal Ir film was analyzed by an X-ray diffraction method. The analysis was performed under the following conditions.

Apparatus: SmartLab manufactured by Rigaku Corporation, with a semiconductor detector, operated at a wavelength of λ = 1.54 Å, a power of 45 kV, and 200 mA; an incident optical system composed of a Ge(220) channel-cut monochromator; Soller slits of 2.5° on an incident side and 2.5° on a receiving side; an incident side slit IS = 1 mm; a length limiting slit of 0.5mm; receiving sides RS 1 of 1.0 mm and RS 2 of 1.1 mm; a step size of 0.004°; and a scan rate of 3°/min.

As a result, the surface was a (111) surface, and there was an off-angle of 4° in the crystal axis [-1-1 2] direction. In addition, the half-width (FWHM) of the diffracted peak at 2θ = 40.7°, assigned to Ir (111, was 0.125°. Hereinafter, this single crystal Ir film will be referred to as "Ir (111) film".

Next, as pre-treatment for forming diamond nuclei, a nucleation treatment (bias treatment) was performed. The substrate was set on a planar electrode with a diameter of 25 mm inside a treatment chamber with the Ir (111) film side facing upwards. After it was confirmed that a base pressure had become 1×10⁻⁶ Torr (about 1.3×10⁻⁴ Pa) or lower, hydrogen-diluted methane gas (CH₄/(CH₄+H₂) = 5.0 volume%) was introduced into the treatment chamber at a flow rate of 500 sccm. After making the pressure 100 Torr (about 1.3×10⁴ Pa) by adjusting the aperture of the valve connected to the exhaust system, a negative voltage was applied to the electrode at the substrate side to expose to plasma for 90 seconds, and thereby the substrate (Ir (111) film) surface was subjected to bias treatment.

Diamond was heteroepitaxially grown by a microwave plasma CVD method on the single crystal MgO (111) substrate on which the Ir (111) film had been formed as described above. The single crystal MgO (111) substrate on which the Ir (111) film was formed, was subjected to bias treatment, and was then set inside the chamber of a microwave plasma CVD apparatus. After it was confirmed that a base pressure had become 1×10⁻⁶ Torr (about 1.3×10⁻⁴ Pa) or lower, a mixed gas of a natural methane gas (purity of 99.9999 volume% or more) and a hydrogen gas (purity of 99.99999 volume% or more), which served as a raw material, was introduced into the chamber at a flow rate of 500 sccm at the following volume ratio.

| | |
|---|---|
| Methane gas | 4.000 volume% |
| Hydrogen gas | 96.000 volume% |

After making the pressure inside the chamber 120 Torr (about 1.6×10⁴ Pa) by adjusting the aperture of the valve connected to the exhaust system, film formation was performed for 71 hours by inputting a microwave of 3000 W, whereby the film formation was performed until the thickness reached about 250 µm (nitrogen-undoped diamond layer).

Subsequently, a ¹²C-enriched methane gas in which methane gas having ¹²C / methane gas having ¹³C = 99.995 volume% / 0.005 volume%, a hydrogen gas (purity of 99.99999 volume% or more), and a nitrogen gas (purity of 99.99999 volume% or more) were added to produce a mixed gas, which served as a raw material. A volume ratio of the mixed gas was changed as follows, and the gas was introduced into the chamber at a flow rate of 500 sccm.

| | |
|---|---|
| Methane gas | 0.100 volume% |
| Hydrogen gas | 99.850 volume% |
| Nitrogen gas | 0.050 volume% |

The pressure and the microwave power were unchanged. Under these conditions, the film forming was performed for 5 hours, thereby forming a nitrogen-doped diamond layer until the thickness thereof reached about 6 µm.

In this manner, diamond layers were heteroepitaxially grown on the single crystal MgO (111) substrate on which the Ir (111) film had been formed, and a laminate substrate was obtained.

Subsequently, the single crystal MgO (111) substrate on which the Ir (111) film had been formed was removed to produce a freestanding substrate. First, after removing the single crystal MgO (111) substrate by wet etching, the Ir (111) film was removed by polishing. As a result, a single crystal diamond (111) laminate substrate having a diameter of 10 mm and composed of a nitrogen-doped single crystal diamond film of about 6 µm and an undoped single crystal diamond (111) substrate of about 250 µm thick was obtained.

The surface side of the diamond substrate having the laminated structure was processed by polishing for completion.

Finally, the finished diamond substrate having a laminated structure was subjected to SIMS, XRD, NVC density and surface roughness analyses.

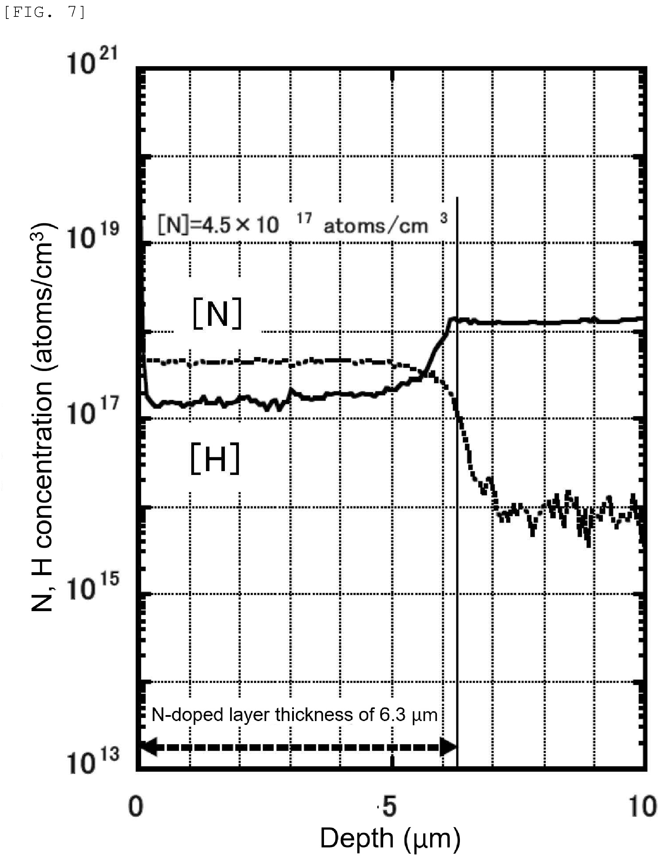

A nitrogen concentration [N] in the diamond crystal was measured using the SIMS measurement apparatus, CAMECA IMS-7f, under conditions of Cs⁺ as primary ion species, a primary accelerating voltage of 16.0 kV, and a detection area diameter of 30 µm. Note that the results of SIMS measurements, including a hydrogen concentration [H] as described later, are summarized in FIG. 7.

As a result, the nitrogen concentration within a depth of about 5 µm from the outermost surface of the film was [N] = 4.5×10¹⁷ atoms/cm³.

In general, the depth at which the value of the nitrogen concentration [N] in a nitrogen-doped diamond film reached 1/e times of the value is regarded as an interface between a nitrogen-doped layer and an undoped layer. In this case, a profile exhibited a steep change within a thickness of about 1.0 µm in an interfacial region.

Then, the hydrogen concentration [H] in the diamond crystal was measured under the same SIMS conditions; as a result, the hydrogen concentration within a depth of about 5 µm from the outermost surface was [H] = 1.5×10¹⁷ atoms/cm³.

Crystallinity was analyzed from the outermost surface of the film under the following conditions: with an X-ray diffraction measurement apparatus SmartLab manufactured by Rigaku Corporation, with a semiconductor detector, operated at a wavelength of λ = 1.54 Å, a power of 45 kV, and 200 mA; an incident optical system composed of a Ge(220) channel-cut monochromator; Soller slits of 2.5° on an incident side and 2.5° on a receiving side; an incident side slit IS = 1 mm; a length limiting slit of 0.5mm; receiving sides RS 1 of 1.0 mm and RS 2 of 1.1 mm; a step size of 0.004°; and a scan rate of 3°/min.

As a result, only a diffraction intensity peak attributable to diamond (111) at 2θ = 43.9° was observed, and it was confirmed that the nitrogen-doped single crystal diamond film was epitaxially grown onto the undoped single crystal diamond (111) layer.

Furthermore, NVC evaluations, such as a photoluminescence measurement, a confocal microscopic observation, an optically detected magnetic resonance (ODMR) measurement, and a Rabi oscillation, were performed using a confocal-microscopy apparatus (incident wavelength of 532 nm).

As a result, NVC light at a wavelength of 637 nm was detected, and NVC density, calculated from a relaxation time of nuclear spins T₂ = 58.2 µs, was 4.4×10¹⁶/cm³.

Accordingly, the obtained nitrogen-doped film was a single crystal diamond (111) crystal in which NVC was formed at a high density.

Moreover, when the surface of the diamond substrate was measured using an atomic force microscope (NanoScope V manufactured by Bruker AXS SE) over a region of 80 µm × 80 µm, an average surface roughness Ra was 187 nm.

Further, an isotope abundance ratio of carbon atoms in the nitrogen-doped layer of the NVC-containing diamond (111) substrate was measured.

Measurement conditions: carbon concentrations [¹²C] and [¹³C] in the diamond crystal were measured using the SIMS measurement apparatus, CAMECA IMS-7f, under the conditions of O₂⁺ as primary ion species, a primary accelerating voltage of 11.0 kV, and a detection area diameter of 30 µm.

As a result, the resulting abundance ratio of ¹²C was 99.995%, which was higher than the abundance ratio of ¹²C in natural carbon atoms (98.89%). In addition, an abundance ratio of ¹³C was 0.005%.

The NVC density and the like in the nitrogen-doped layer in Example 1 were as follows.
Nitrogen concentration: 4.5×10¹⁷ atoms/cm³
Hydrogen concentration: 1.5×10¹⁷ atoms/cm³
NVC density: 4.4×10¹⁶/cm³
Abundance ratio of ¹²C and ¹³C: 99.995% of ¹²C and 0.005% of ¹³C
Steepness in an interfacial region: about 1.0 µm

### (Example 2)

As an underlying substrate, a single crystal diamond substrate polished on one side having a 2 mm square, a thickness of 200 µm, a main surface that was (111), and an off angle of 4.0° in a crystal axis [-1-1 2] direction was provided. A method for manufacturing this single crystal diamond substrate was as follows.

First, the same procedures as in Example 1 were performed until the formation of a nitrogen-undoped single crystal diamond layer to obtain a laminate of a nitrogen-undoped single crystal diamond layer, a Ir (111) film, and a single crystal MgO (111) substrate. Next, the Ir (111) film and the single crystal MgO (111) substrate were removed to produce a freestanding substrate. Specifically, after removing the single crystal MgO (111) substrate by wet etching, the Ir (111) film was removed by polishing. Subsequently, laser cutting was performed to obtain a freestanding nitrogen-undoped single crystal diamond (111) single layer substrate having a 2 mm square and a thickness of 250 µm. The surface side of the substrate was processed by polishing to obtain a single crystal diamond substrate to be an underlying substrate, polished on one side, having a 2 mm square, a thickness of about 200 µm, a main surface that was (111), and an off angle of 4° in a crystal axis [-1-1 2] direction.

A nitrogen-doped single crystal diamond was epitaxially grown on the underlying substrate produced as described above by a microwave plasma CVD method. The underlying substrate was set inside the chamber of a microwave plasma CVD apparatus. After it was confirmed that a base pressure had become 1×10⁻⁶ Torr (about 1.3×10⁻⁴ Pa) or lower, a mixed gas, which served as a raw material, was introduced into the chamber at a flow rate of 500 sccm. This mixed gas was prepared by adding a ¹²C-enriched methane gas having a ratio of a methane gas having ¹²C / a methane gas having ¹³C = 99.995 volume% / 0.005 volume%, a hydrogen gas (purity of higher than 99.99999 volume%), and further, a nitrogen gas (purity of higher than 99.99995 volume%) at the following volume ratio.

| | |
|---|---|
| Methane gas | 0.100 volume% |
| Hydrogen gas | 99.850 volume% |
| Nitrogen gas | 0.050 volume% |

After making the pressure inside the chamber 120 Torr (about 1.6×10⁴ Pa) by adjusting the aperture of the valve connected to the exhaust system, film formation was performed for 96 hours by inputting a microwave power of 3500 W, whereby the film formation was performed until a thickness of a nitrogen-doped single crystal diamond layer reached about 218 µm.

In this way, a laminated diamond substrate composed of the nitrogen-doped single crystal diamond layer and the undoped single crystal diamond (111) substrate was obtained.

Finally, the finished laminate substrate was subjected to respective SIMS and XRD analyses.

Next, as a result of measurements of a nitrogen concentration [N] and a hydrogen concentration [H] in the diamond crystal under the same SIMS conditions as in Example 1, the nitrogen concentration within a depth of about 5 µm from the outermost surface was [N] = 1.4×10¹⁸ atoms/cm³, and the hydrogen concentration was [H] = 1.5×10¹⁷ atoms/cm³.

Note that a steepness (the thickness of the decreasing region in which a concentration reaches 1/e times) of a nitrogen concentration profile at an interfacial region in the nitrogen-doped layer was about 1.0 µm.

Crystallinity was measured from the outermost surface of the film under the following conditions: with an X-ray diffraction measurement apparatus SmartLab manufactured by Rigaku Corporation, with a semiconductor detector, operated at a wavelength of λ = 1.54 Å, a power of 45 kV, and 200 mA; an incident optical system composed of a Ge(220) channel-cut monochromator; Soller slits of 2.5° on an incident side and 2.5° on a receiving side; an incident side slit IS = 1 mm; a length limiting slit of 0.5 mm; receiving sides RS 1 of 1.0 mm and RS 2 of 1.1 mm; a step size of 0.004°; and a scan rate of 3°/min.

As a result, only a diffraction intensity peak attributable to diamond (111) at 2θ = 43.9° was observed, and it was confirmed that the nitrogen-doped single crystal diamond film was epitaxially grown onto the undoped single crystal diamond (111) layer.

Furthermore, NVC evaluations, such as a photoluminescence measurement, a confocal microscopic observation, an optically detected magnetic resonance (ODMR) measurement, and a Rabi oscillation, were performed using a confocal-microscopy apparatus (incident wavelength of 532 nm).

As a result, NVC light at a wavelength of 637 nm was detected, and NVC density calculated from a relaxation time of nuclear spins T₂ = 19.9 µs was 1.4×10¹⁷/cm³.

Accordingly, the obtained nitrogen-doped film was a single crystal diamond (111) crystal in which NVC was formed at a high density.

Further, an isotope abundance ratio of carbon atoms in the nitrogen-doped layer of the NVC-containing diamond (111) substrate was measured under the same conditions in Example 1.

As a result, the abundance ratio of ¹²C was 99.995%, and the abundance ratio of ¹³C was 0.005%.

When the NVC-containing diamond (111) substrate was applied to electronic and magnetic devices, high-performance devices can be obtained. For example, highly sensitive magnetic sensors can be obtained.

The NVC density and the like in the nitrogen-doped layer in Example 2 were as follows.
Nitrogen concentration: 1.4×10¹⁸ atoms/cm³
Hydrogen concentration: 1.5×10¹⁷ atoms/cm³
NVC density: 1.4×10¹⁷/cm³
Abundance ratio of ¹²C and ¹³C: 99.995% of ¹²C and 0.005% of ¹³C
Steepness in an interfacial region: about 1.0 µm

### (Comparative Example 1)

When a nitrogen-doped single crystal diamond was epitaxially grown, a natural methane gas without carbon isotope enrichment (purity of 99.9999 volume% or more) was used as a methane gas in a raw material. By following the production procedures as in Example 2, except for the conditions described above, a laminated diamond substrate composed of a nitrogen-doped single crystal diamond layer and an undoped single crystal diamond (111) substrate was obtained.

Crystallinity determined by XRD, and a nitrogen concentration [N] and a hydrogen concentration [H] determined by SIMS were the same as those in Example 2. Other characteristics are summarized as follows.
Nitrogen concentration: 1.4×10¹⁸ atoms/cm³
Hydrogen concentration: 1.5×10¹⁷ atoms/cm³
NVC density: 1.2×10¹⁶/cm³
Abundance ratio of ¹²C and ¹³C: 98.892% of ¹²C and 1.108% of ¹³C (approximately the same abundance ratio as that in natural gas)
Steepness in an interfacial region: about 2.5 µm (significantly gentler than those in Examples 1 and 2)

### (Example 3)

When a nitrogen-doped single crystal diamond was epitaxially grown, a mixed gas was prepared from the following gases.
Methane gas 0.005 volume% (methane gas having ¹²C / methane gas having ¹³C = 99.500 volume% / 0.500 volume%)
Hydrogen gas 99.945 volume%
Nitrogen gas 0.050 volume%

By following the production procedures as in Example 2, except for the conditions described above, a laminated diamond substrate composed of a nitrogen-doped single crystal diamond layer and an undoped single crystal diamond (111) substrate was obtained.

The results of various measurements were as follows.
Nitrogen concentration: 1.5×10¹⁸ atoms/cm³
Hydrogen concentration: 1.5×10¹⁷ atoms/cm³
NVC density: 1.2×10¹⁷/cm³
Abundance ratio of ¹²C and ¹³C: 99.500% of ¹²C and 0.500% of ¹³C
Steepness in an interfacial region: about 1.0 µm

### (Example 4)

When a nitrogen-doped single crystal diamond was epitaxially grown, a mixed gas, which served as a raw material, having a volume ratio described below, was prepared. This mixed gas was prepared by adding a ¹²C-enriched methane gas having a ratio of a methane gas having ¹²C / a methane gas having ¹³C = 99.995 volume% / 0.005 volume%, a hydrogen gas (purity of higher than 99.99999 volume%), and further, a nitrogen gas (purity of higher than 99.99995 volume%).

| | |
|---|---|
| Methane gas | 7.000 volume% |
| Hydrogen gas | 92.950 volume% |
| Nitrogen gas | 0.050 volume% |

By following the production procedures as in Example 2, except for the conditions described above, a laminated diamond substrate composed of a nitrogen-doped single crystal diamond layer and an undoped single crystal diamond (111) substrate was obtained.

The results of respective measurements were as follows.
Nitrogen concentration: 1.0×10¹⁸ atoms/cm³
Hydrogen concentration: 1.5×10¹⁷ atoms/cm³
NVC density: 9.5×10¹⁶/cm³
Abundance ratio of ¹²C and ¹³C: 99.995% of ¹²C and 0.005% of ¹³C
Steepness in an interfacial region: about 1.2 µm

### (Comparative Example 2)

When a nitrogen-doped single crystal diamond was epitaxially grown, a mixed gas described below was prepared.

| | |
|---|---|
| Methane gas | 0.001 volume% |
| Hydrogen gas | 99.949 volume% |
| Nitrogen gas | 0.050 volume% |

By following the production procedures as in Example 2, except for the conditions described above, an attempt was made to manufacture a laminated diamond substrate composed of a nitrogen-doped single crystal diamond layer and an undoped single crystal diamond (111) substrate.

However, the volume ratio of the methane gas was likely too low, leading to difficulty in growing the nitrogen-doped single crystal diamond; accordingly, film formation was terminated halfway through.

### (Comparative Example 3)

When a nitrogen-doped single crystal diamond was epitaxially grown, a mixed gas described below was prepared.

| | |
|---|---|
| Methane gas | 14.000 volume% |
| Hydrogen gas | 85.950 volume% |
| Nitrogen gas | 0.050 volume% |

By following the production procedures as in Example 2, except for the conditions described above, an attempt was made to manufacture a laminated diamond substrate composed of a nitrogen-doped single crystal diamond layer and an undoped single crystal diamond (111) substrate.

However, the volume ratio of the methane gas was likely too high, leading to polycrystallization of diamond in the nitrogen-doped layer.

### (Comparative Example 4)

When a nitrogen-doped single crystal diamond was epitaxially grown, a mixed gas described below was prepared.

| | |
|---|---|
| Methane gas | 0.100 volume% |
| Hydrogen gas | about 99.850 volume% |
| Nitrogen gas | 0.00001 volume% |

By following the production procedures as in Example 2, except for the conditions described above, a laminated diamond substrate composed of a nitrogen-doped single crystal diamond layer and an undoped single crystal diamond (111) substrate was obtained.

However, the volume ratio of the nitrogen gas was likely too low, leading to significantly low NVC density compared to that in each of Examples and Comparative Example 1.

### (Comparative Example 5)

When a nitrogen-doped single crystal diamond was epitaxially grown, a mixed gas described below was prepared.

| | |
|---|---|
| Methane gas | 0.100 volume% |
| Hydrogen gas | 85.900 volume% |
| Nitrogen gas | 14.000 volume% |

By following the production procedures as in Example 2, except for the conditions described above, an attempt was made to manufacture a laminated diamond substrate composed of a nitrogen-doped single crystal diamond layer and an undoped single crystal diamond (111) substrate.

However, the volume ratio of the nitrogen gas was likely too high, leading to polycrystallization of diamond in the nitrogen-doped layer.

As described above, in the inventive products in Examples 1 to 4, the products having high-density NVCs were successfully produced. Therefore, a highly sensitive sensor can be produced. In contrast, when the conditions according to the present invention were not satisfied, as in Comparative Example 1, even though the nitrogen concentration or the like was comparable to those of the inventive products, the NVC densities were inferior to those of the inventive products. Moreover, in Comparative Examples 2, 3, and 5, the growth of the nitrogen-doped single crystal diamond layer was insufficient in the first place. Further, in Comparative Example 4, the NVC density was significantly reduced.

### (Example 5)

Even when undoped and nitrogen-doped single crystal diamonds as in Examples 1 and 2 were formed by respective CVD methods including a direct current plasma CVD method, a hot-filament CVD method and an arc discharge plasma jet CVD method, or even when formed by a plurality of CVD methods in combination, respective nitrogen-doped layers obtained was a single crystal diamond (111) crystal having a NVC density of about 4.4×10¹⁶ to 1.4×10¹⁷/cm³.

In addition, results of various measurements for abundance ratios of ¹²C and ¹³C, and steepness in an interfacial region were also comparable to those in each of Examples and exhibited excellent values.

### (Examples 6 and 7)

When nitrogen-doped single crystal diamonds were epitaxially grown, a nitrogen gas contained in a mixed gas used was changed to 5.0×10⁻⁵ volume% (in Example 6) or to 8.000 volume% (in Example 7) in comparison with that in Example 2. Accordingly, a volume% of hydrogen gas was adjusted to compensate.

By following the production procedures as in Example 2, except for the conditions described above, a laminated diamond substrate composed of a nitrogen-doped single crystal diamond layer and an undoped single crystal diamond (111) substrate was obtained.

Each of the nitrogen-doped single crystal diamonds was not polycrystallized, and the results of respective measurements thereof were also comparable to those of other Examples; furthermore, NVC densities were more excellent than those in each of Comparative Examples.

The present description includes the following embodiments.
[1]: A method for manufacturing a diamond substrate by forming a diamond crystal on an underlying substrate using a source gas containing a hydrogen gas as a dilution gas and a hydrocarbon gas by any one of chemical vapor deposition (CVD) methods, wherein
   in order to form a diamond crystal layer having nitrogen-vacancy centers in at least a part of the diamond crystal to be formed on the underlying substrate, a nitrogen gas or a nitride gas is mixed in the source gas, and amounts of respective gases contained in the source gas satisfy:
   0.005 volume% or more and 7.000 volume% or less of the hydrocarbon gas;
   85.000 volume% or more and less than 99.995 volume% of the hydrogen gas; and
   5.0×10⁻⁵ volume% or more and 8.000 volume% or less of the nitrogen gas or the nitride gas,
   to thereby form the diamond crystal layer having the nitrogen-vacancy centers, and
   as the hydrocarbon gas contained in the source gas, a ¹²C-enriched hydrocarbon gas is used, in which a proportion of a hydrocarbon gas having ¹²C, which is an isotope of carbon, is higher than a proportion of the hydrocarbon gas having ¹²C in a natural hydrocarbon gas.
[2]: The method for manufacturing a diamond substrate of the above [1], wherein
   the source gas further contains an oxygen gas or an oxide gas in an amount of 0.010 volume% or more and 2.000 volume% or less.
[3]: The method for manufacturing a diamond substrate of the above [1] or [2], wherein
   the hydrocarbon gas contained in the source gas is a methane gas.
[4]: The method for manufacturing a diamond substrate of any of the above [1] to [3], wherein
   a gas pressure in the formation of the diamond crystal by the CVD method is 1.3 kPa (10 Torr) or more and 50.0 kPa (376 Torr) or less.
[5]: The method for manufacturing a diamond substrate of any of the above [1] to [4], wherein
   the ¹²C-enriched hydrocarbon gas has a volume ratio of the hydrocarbon gas having ¹²C in the ¹²C-enriched hydrocarbon gas of 99.950 volume% or more.
[6]: The method for manufacturing a diamond substrate of any of the above [1] to [5], wherein
   the ¹²C-enriched hydrocarbon gas has a volume ratio of the hydrocarbon gas having ¹³C in the ¹²C-enriched hydrocarbon gas of 0.040 volume% or less.
[7]: The method for manufacturing a diamond substrate of any of the above [1] to [6], wherein
   the underlying substrate is a single layer substrate of a single crystal diamond.
[8]: The method for manufacturing a diamond substrate of the above [7], wherein
   the single layer substrate of a single crystal diamond is any of a high-pressure-high-temperature-synthesized single crystal diamond layer, a heteroepitaxial single crystal diamond layer, or a CVD-synthesized homoepitaxial diamond layer.
[9]: The method for manufacturing a diamond substrate of any of the above [1] to [8], wherein
   in forming the diamond crystal by the CVD method, when forming a diamond crystal layer that does not contain the nitrogen-vacancy centers, the natural hydrocarbon gas is used.
[10]: The method for manufacturing a diamond substrate of any of the above [1] to [9], wherein
   the underlying substrate has a laminated structure comprising an underlayer substrate and an intermediate layer on the underlayer substrate.
[11]: The method for manufacturing a diamond substrate of the above [10], wherein
   the intermediate layer has an outermost surface that is a metal layer selected from Ir, Rh, Pd, and Pt.
[12]: The method for manufacturing a diamond substrate of any of the above [1] to [11], wherein
   the CVD method comprises any one or more of a microwave plasma CVD method, a direct current plasma CVD method, a hot-filament CVD method, and an arc discharge plasma jet CVD method.
[13]: A method for manufacturing a diamond substrate, wherein the underlying substrate is removed from the diamond substrate comprising the diamond crystal layer having the nitrogen-vacancy centers obtained by the method for manufacturing a diamond substrate of any of the above [1] to [12] to obtain a freestanding single crystal diamond substrate comprising the diamond crystal layer having the nitrogen-vacancy centers.
[14]: A method for manufacturing a diamond substrate comprising smoothing a surface of the diamond crystal layer having the nitrogen-vacancy centers of the diamond substrate comprising the diamond crystal layer having the nitrogen-vacancy centers obtained by the method for manufacturing a diamond substrate of any of the above [1] to [13].
[15]: A diamond substrate comprising a diamond crystal layer having nitrogen-vacancy centers, wherein
   the diamond crystal layer having the nitrogen-vacancy centers is formed on a diamond crystal layer that does not contain the nitrogen-vacancy centers or a single layer substrate of a single crystal diamond,
   in carbon atoms present in the diamond crystal layer having the nitrogen-vacancy centers, an abundance ratio of ¹²C, which is an isotope of carbon, is higher than an abundance ratio in natural carbon atoms, and
   a profile of a nitrogen concentration in the diamond crystal layer having the nitrogen-vacancy centers is steep in an interfacial region with the diamond crystal layer that does not contain the nitrogen-vacancy centers or with the single layer substrate of a single crystal diamond.
[16]: The diamond substrate of the above [15], wherein
   when the profile of the nitrogen concentration in the diamond crystal layer having the nitrogen-vacancy centers is measured by a secondary ion mass spectrometry apparatus using Cs⁺ as primary ion species, at a primary accelerating voltage of 16.0 kV, and with a detection area diameter of 30 µm, a thickness of a decreasing region of the profile of the nitrogen concentration until the nitrogen concentration [N] reaches 1/e (Napier's constant) times is 1.5 µm or less in the interfacial region with the diamond crystal layer that does not contain the nitrogen-vacancy centers or the single layer substrate of a single crystal diamond.
[17]: The diamond substrate of the above [16], wherein
   a hydrogen concentration [H] is 1×10¹⁶ atoms/cm³ or more in the diamond crystal layer having the nitrogen-vacancy centers.
[18]: The diamond substrate of any of the above [15] to [17], wherein
   the nitrogen concentration [N] in the diamond crystal layer having the nitrogen-vacancy centers is 1×10¹⁷ atoms/cm³ ≤ [N] ≤ 9×10¹⁹ atoms/cm³.
[19]: The diamond substrate of any of the above [15] to [18], wherein
   an average surface roughness Ra of a surface of the diamond crystal layer having the nitrogen-vacancy centers is Ra ≤ 260 nm.
[20]: A sensor comprising the diamond substrate of any of the above [15] to [19].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing a diamond substrate by forming a diamond crystal on an underlying substrate using a source gas containing a hydrogen gas as a dilution gas and a hydrocarbon gas by a chemical vapor deposition (CVD) method, wherein
in order to form a diamond crystal layer having nitrogen-vacancy centers in at least a part of the diamond crystal to be formed on the underlying substrate, a nitrogen gas or a nitride gas is mixed in the source gas, and amounts of respective gases contained in the source gas satisfy:
0.005 volume% or more and 7.000 volume% or less of the hydrocarbon gas;
85.000 volume% or more and less than 99.995 volume% of the hydrogen gas; and
5.0×10⁻⁵ volume% or more and 8.000 volume% or less of the nitrogen gas or the nitride gas,
to thereby form the diamond crystal layer having the nitrogen-vacancy centers, and
as the hydrocarbon gas contained in the source gas, a ¹²C-enriched hydrocarbon gas is used, in which a proportion of a hydrocarbon gas having ¹²C, which is an isotope of carbon, is higher than a proportion of the hydrocarbon gas having ¹²C in a natural hydrocarbon gas.

2. The method for manufacturing a diamond substrate according to claim 1, wherein
the source gas further contains an oxygen gas or an oxide gas in an amount of 0.010 volume% or more and 2.000 volume% or less.

3. The method for manufacturing a diamond substrate according to claim 1 or 2, wherein
the hydrocarbon gas contained in the source gas is a methane gas.

4. The method for manufacturing a diamond substrate according to claim 1 or 2, wherein
a gas pressure in the formation of the diamond crystal by the CVD method is 1.3 kPa (10 Torr) or more and 50.0 kPa (376 Torr) or less.

5. The method for manufacturing a diamond substrate according to claim 1 or 2, wherein
the ¹²C-enriched hydrocarbon gas has a volume ratio of the hydrocarbon gas having ¹²C in the ¹²C-enriched hydrocarbon gas of 99.950 volume% or more.

6. The method for manufacturing a diamond substrate according to claim 1 or 2, wherein
the ¹²C-enriched hydrocarbon gas has a volume ratio of the hydrocarbon gas having ¹³C in the ¹²C-enriched hydrocarbon gas of 0.040 volume% or less.

7. The method for manufacturing a diamond substrate according to claim 1 or 2, wherein
the underlying substrate is a single layer substrate of a single crystal diamond.

8. The method for manufacturing a diamond substrate according to claim 7, wherein
the single layer substrate of a single crystal diamond is any of a high-pressure-high-temperature-synthesized single crystal diamond layer, a heteroepitaxial single crystal diamond layer, or a CVD-synthesized homoepitaxial diamond layer.

9. The method for manufacturing a diamond substrate according to claim 1 or 2, wherein
in forming the diamond crystal by the CVD method, when forming a diamond crystal layer that does not contain the nitrogen-vacancy centers, the natural hydrocarbon gas is used.

10. The method for manufacturing a diamond substrate according to claim 1 or 2, wherein
the underlying substrate has a laminated structure comprising an underlayer substrate and an intermediate layer on the underlayer substrate.

11. The method for manufacturing a diamond substrate according to claim 10, wherein
the intermediate layer has an outermost surface that is a metal layer selected from Ir, Rh, Pd, and Pt.

12. The method for manufacturing a diamond substrate according to claim 1 or 2, wherein
the CVD method comprises any one or more of a microwave plasma CVD method, a direct current plasma CVD method, a hot-filament CVD method, and an arc discharge plasma jet CVD method.

13. A method for manufacturing a diamond substrate, wherein the underlying substrate is removed from the diamond substrate comprising the diamond crystal layer having the nitrogen-vacancy centers obtained by the method for manufacturing a diamond substrate according to claim 1 or 2 to obtain a freestanding single crystal diamond substrate comprising the diamond crystal layer having the nitrogen-vacancy centers.

14. A method for manufacturing a diamond substrate comprising smoothing a surface of the diamond crystal layer having the nitrogen-vacancy centers of the diamond substrate comprising the diamond crystal layer having the nitrogen-vacancy centers obtained by the method for manufacturing a diamond substrate according to claim 1 or 2.

15. A diamond substrate comprising a diamond crystal layer having nitrogen-vacancy centers, wherein
the diamond crystal layer having the nitrogen-vacancy centers is formed on a diamond crystal layer that does not contain the nitrogen-vacancy centers or a single layer substrate of a single crystal diamond,
in carbon atoms present in the diamond crystal layer having the nitrogen-vacancy centers, an abundance ratio of ¹²C, which is an isotope of carbon, is higher than an abundance ratio in natural carbon atoms, and
a profile of a nitrogen concentration in the diamond crystal layer having the nitrogen-vacancy centers is steep in an interfacial region with the diamond crystal layer that does not contain the nitrogen-vacancy centers or with the single layer substrate of a single crystal diamond.

16. The diamond substrate according to claim 15, wherein
when the profile of the nitrogen concentration in the diamond crystal layer having the nitrogen-vacancy centers is measured by a secondary ion mass spectrometry apparatus using Cs⁺ as primary ion species, at a primary accelerating voltage of 16.0 kV, and with a detection area diameter of 30 µm, a thickness of a decreasing region of the profile of the nitrogen concentration until the nitrogen concentration [N] reaches 1/e (Napier's constant) times is 1.5 µm or less in the interfacial region with the diamond crystal layer that does not contain the nitrogen-vacancy centers or the single layer substrate of a single crystal diamond.

17. The diamond substrate according to claim 16, wherein
a hydrogen concentration [H] is 1×10¹⁶ atoms/cm³ or more in the diamond crystal layer having the nitrogen-vacancy centers.

18. The diamond substrate according to any one of claims 15 to 17, wherein
the nitrogen concentration [N] in the diamond crystal layer having the nitrogen-vacancy centers is 1×10¹⁷ atoms/cm³ ≤ [N] ≤ 9×10¹⁹ atoms/cm³.

19. The diamond substrate according to any one of claims 15 to 17, wherein
an average surface roughness Ra of a surface of the diamond crystal layer having the nitrogen-vacancy centers is Ra ≤ 260 nm.

20. A sensor comprising the diamond substrate according to any one of claims 15 to 17.
